# FASCICULE DE BREVET EUROPEEN

(11) **EP 3 830 639 B1**
(45) Date de publication et mention de la délivrance du brevet: **02.08.2023**
(21) Numéro de dépôt: 19737104.0
(22) Date de dépôt: 09.07.2019
(51) Int. Cl.: G02F 1/1345, H05K 3/32, H05K 3/36, H05K 1/11, G02F 1/133, B60K 35/00

(54) **SYSTEME D'AFFICHAGE ET PLANCHE DE BORD**
ANZEIGESYSTEM UND ARMATURENBRETT
DISPLAY SYSTEM AND DASHBOARD

(30) Priorité: 30.07.2018 FR 1857109
(43) Date de publication de la demande: 09.06.2021
(73) Titulaire: Valeo Comfort and Driving Assistance, 94000 Créteil (FR)
(72) Inventeur: BEZ, David, 94046 Créteil CEDEX (FR)
(74) Mandataire: Delplanque, Arnaud
(86) Numéro de dépôt international: PCT/EP2019/068457
(87) Numéro de publication internationale: WO 2020/025269

(56) Documents cités:
- JP-A- 2016 119 205
- US-A1- 2009 033 825
- US-A1- 2016 327 841

## Description

### DOMAINE TECHNIQUE AUQUEL SE RAPPORTE L'INVENTION

La présente invention concerne de manière générale le domaine des systèmes d'affichage, notamment dans un véhicule automobile.

Elle concerne plus particulièrement un système d'affichage et une planche de bord.

Elle concerne en particulier la connexion électrique entre un écran d'affichage et le circuit imprimé du système d'affichage.

### ARRIERE-PLAN TECHNOLOGIQUE

Les véhicules automobiles sont souvent équipés de systèmes d'affichage communiquant au conducteur diverses informations concernant l'état du véhicule. Selon une disposition envisageable, de tels systèmes d'affichage comprennent un écran d'affichage, un circuit imprimé et un support interposé entre l'écran d'affichage et le circuit imprimé. Le support permet d'assembler l'écran d'affichage et le circuit imprimé. Il permet en outre de les maintenir dans la planche de bord du véhicule et de rigidifier l'ensemble.

Afin de relier électriquement l'écran d'affichage au circuit imprimé, des câbles de connexion passent à travers des ouvertures ménagées dans le support.

Le système d'affichage étant généralement placé dans une zone du véhicule accessible par des utilisateurs, le support doit montrer une grande résistance à l'effort afin de résister à d'éventuelles manipulations de ces utilisateurs. Un système d'affichage de l'état de la technique pertinent est connu de document JP 2016 119205 A.

### OBJET DE L'INVENTION

Dans ce contexte, la présente invention propose un système d'affichage comprenant :
- un écran d'affichage,
- un circuit imprimé,
- un support interposé entre l'écran d'affichage et le circuit imprimé, l'écran d'affichage comprenant une face électriquement conductrice dirigée vers le support,
la face électriquement conductrice étant reliée (électriquement) à une région électriquement conductrice du support par un élément électriquement conducteur, la région électriquement conductrice du support étant reliée (électriquement) à une masse du circuit imprimé, le support comprenant une plaque présentant un logement accueillant l'écran d'affichage.

Ainsi, la connexion de l'écran d'affichage à la masse du circuit imprimé est fournie par l'intermédiaire de l'élément électriquement conducteur en contact avec la région électriquement conductrice du support, qui est elle-même reliée à la masse du circuit imprimée. La connexion de l'écran d'affichage à la masse est réalisée sans avoir à ménager d'ouverture dans le support pour y faire passer un câble de masse. En minimisant le nombre d'ouvertures du support, celui-ci conserve une bonne résistance à l'effort.

De plus, la liaison électrique à la masse est réalisée de manière simple par l'intermédiaire du support et donc sans avoir à prévoir des moyens plus complexes liant directement l'écran d'affichage au circuit imprimé.

D'autres caractéristiques non limitatives et avantageuses du système d'affichage conforme à l'invention, prises individuellement ou selon toutes les combinaisons techniquement possibles, sont les suivantes :
- l'élément électriquement conducteur comprend une patte métallique,
- le support est fabriqué en matériau électriquement conducteur au moins au niveau de la région électriquement conductrice,
- le matériau électriquement conducteur comprend du magnésium ou un autre métal,
- la région électriquement conductrice du support est reliée à la masse du circuit imprimé par un autre élément électriquement conducteur,
- l'autre élément conducteur comprend une autre patte métallique,
- il est prévu un câble électrique connectant l'écran d'affichage au circuit imprimé,
- le câble électrique passe à travers une ouverture ménagée dans le logement,
- il est prévu un écran de protection fixé sur une face de l'écran d'affichage opposé à face dirigée vers le support.

L'invention propose également une planche de bord comprenant le système d'affichage tel que précité, dans lequel le support est fixé sur la planche de bord.

### DESCRIPTION DETAILLEE D'UN EXEMPLE DE REALISATION

La description qui va suivre en regard des dessins annexés, donnés à titre d'exemples non limitatifs, fera bien comprendre en quoi consiste l'invention et comment elle peut être réalisée.

Sur les dessins annexés :
- la figure 1 représente schématiquement une vue éclatée des principaux éléments d'un système d'affichage selon l'invention,
- la figure 2 représente un écran d'affichage du système de la figure 1 portant un élément électriquement conducteur, et
- la figure 3 représente schématiquement le système d'affichage de la figure 1 assemblé.

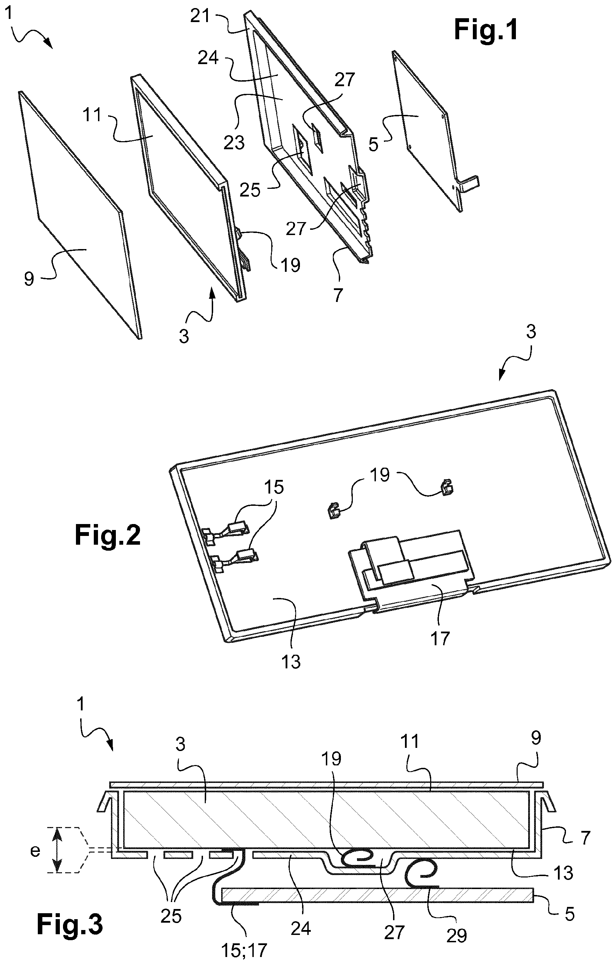

Sur la figure 1, on a représenté un système d'affichage 1 comprenant un écran d'affichage 3, un circuit imprimé 5 et un support 7 interposé entre l'écran d'affichage 3 et le circuit imprimé 5.

Le système d'affichage 1 est par exemple embarqué dans un véhicule automobile. Le système d'affichage 1 est alors placé au niveau d'une planche de bord d'un véhicule automobile. Le système d'affichage 1 communique, à l'occupant du véhicule, des informations en les affichant sur une face de visualisation 11 de l'écran d'affichage 3.

Le système d'affichage 1 est par exemple un tableau de bord placé derrière le volant du véhicule. Le système d'affichage 1 communique alors à l'occupant du véhicule, des informations relatives au fonctionnement du véhicule, notamment la vitesse du véhicule, son niveau de carburant ou bien encore le nombre de révolution par minute du moteur du véhicule.

Le système d'affichage 1 est aussi par exemple l'écran central du véhicule, placé au centre de la planche de bord entre deux sièges avant du véhicule. Le système d'affichage 1 communique alors à l'occupant, des informations géographiques, notamment une carte routière indiquant l'emplacement du véhicule, ou bien encore des informations relatives au système audio ou à la climatisation du véhicule.

Avantageusement, le système d'affichage 1 comprend en outre un écran de protection 9 recouvrant la face de visualisation 11 de l'écran d'affichage 3. L'écran de protection 9 est par exemple une vitre, un film transparent ou toute autre matière translucide solide.

L'écran de protection 9 renforce la face de visualisation 11 de l'écran d'affichage 3 et la protège notamment, de la lumière du soleil, de la poussière et d'éventuelles projections.

Le support 7 du système d'affichage 1 est fixé à la planche de bord. Le support 7 comprend une plaque 21 présentant un logement 23 pour accueillir l'écran d'affichage 3.

Le logement 23 présente une paroi 24 dirigée vers une face électriquement conductrice 13 de l'écran d'affichage 3 opposée à la face de visualisation 11. La paroi 24 du logement 23 présente ici, au moins un renfoncement 27 faisant saillie en direction du circuit imprimé 5.

Sur l'exemple illustré par la figure 1, la paroi 24 du logement 23 présente deux renfoncements 27.

La paroi 24 est majoritairement pleine. La paroi 24 comporte toutefois, ici, au moins une ouverture 25.

Le support 7 présente au moins une région électriquement conductrice au niveau du logement 23. Par exemple, les régions électriquement conductrices sont situées au moins dans les renfoncements 27.

Les régions électriquement conductrices sont par exemple fabriquées à partir de métal, par exemple en magnésium.

De façon avantageuse, le support 7 est fabriqué à partir d'un matériau métallique ainsi la région électriquement conductrice s'étend sur tout le support 7. Le support 7 est par exemple réalisé par à partir d'une tôle de magnésium emboutie ou moulée. Une telle méthode de réalisation facilite la fabrication du support 7.

Le circuit imprimé 5 porte une pluralité de composants électroniques du système d'affichage 1. En particulier, certain de ces composants au moins sont reliés électriquement à des composants électroniques de l'écran 3 (notamment via des connecteurs 15, 17 décrits ci-après) le circuit imprimé permet de connecter l'écran d'affichage 3 à un circuit intégré (non représenté) du système d'affichage 1.

L'écran d'affichage 3, illustré par la figure 2, est par exemple un écran à cristaux liquides.

La face électriquement conductrice 13 opposée à la face de visualisation 11 est dirigée vers le support 7. La face électriquement conductrice 13 est fabriquée à partir d'un matériau métallique, par exemple de l'acier (éventuellement embouti).

L'écran d'affichage 3 comprend une pluralité de zones de connexion (non représentées) situées au niveau de la face électriquement conductrice 13 (en étant isolées de celle-ci par des moyens adéquats). Des connecteurs 15, 17 sont fixés aux zones de connexion. Les connecteurs 15, 17 comprennent par exemple des câbles, nappes de câbles ou pattes électriquement conductrices.

Des premiers connecteurs 15 permettent, par exemple, d'alimenter l'écran d'affichage 3 en électricité.

Un deuxième connecteur 17 permet, par exemple, de transmettre un flux de données, par exemple vidéo, entre l'écran d'affichage 3 et le circuit imprimé 5.

Le système d'affichage 1 comprend au moins un élément électriquement conducteur 19 interposé entre l'écran d'affichage 3 et le support 7.

Dans l'exemple illustré, deux éléments électriquement conducteurs 19 sont fixés sur la face conductrice 13. Les éléments conducteurs 19 sont situés en regard des régions conductrices du support, ici en regard des renfoncements 27.

Les éléments électriquement conducteurs 19 fournissent une connexion électrique entre l'écran d'affichage 3 et la région électriquement conductrice du support 7.

Les éléments électriquement conducteurs 19 sont par exemple des pattes métalliques comme des doigts de blindage. Les doigts de blindage comprennent une partie élastique formant un ressort.

Alternativement, les éléments électriquement conducteurs 19 peuvent être fixés sur les régions conductrices du support 7. Les éléments électriquement conducteurs 19 seraient alors, suivant cet exemple, fixés dans les renfoncements 27.

La figure 3 représente le système d'affichage 1 assemblé.

L'élément électriquement conducteur 19 est logé dans le renfoncement 27 du support 7. Grâce à sa partie élastique, l'élément électriquement conducteur 19 exerce une force en direction du support 7, et établit ainsi une connexion électrique entre la face électriquement conductrice 13 de l'écran d'affichage 3 et la région électriquement conductrice du support 7.

Les dimensions des renfoncements 27 sont déterminées de sorte que les éléments électriquement conducteurs 19 puissent établir un contact électrique entre la face électriquement conductrice 13 et avec les régions électriquement conductrices du support 7. Pour des éléments électriquement conducteurs 19 dont la taille est proche de l'écart e (bien visible sur la figure 3) entre la face électriquement conductrice 13 et le support 7, les renfoncements ne sont pas nécessaires.

Le système d'affichage 1 comprend en outre au moins un autre élément électriquement conducteur 29 reliant électriquement la région conductrice du support 7 à la masse du circuit imprimé 5. Un tel autre élément électriquement conducteur 29 est par exemple interposé entre le support 7 et une piste conductrice de masse du circuit imprimé 5. L'autre élément électriquement conducteur 29 est en contact avec le support 7 et ladite piste conductrice. Dans l'exemple illustré, tout le support 7 est électriquement conducteur, ainsi l'autre élément électriquement conducteur 29 est décalé par rapport à l'élément électriquement conducteur 19. Alternativement, l'autre élément électriquement conducteur 29 peut être disposé en regard de l'élément électriquement conducteur 19.

L'autre élément électriquement conducteur 29 est par exemple une patte métallique comme un doigt de blindage.

L'autre élément électriquement conducteur 29 est par exemple fixé au circuit imprimé. Grâce à sa partie élastique, l'autre élément électriquement conducteur 29 exerce une force en direction de la région conductrice du support 7, et établit ainsi une connexion électrique entre une masse du circuit imprimé et la région conductrice du support 7.

Le support 7 électriquement conducteur est donc relié électriquement d'une part à la masse du circuit imprimé 5, grâce à l'autre élément électriquement conducteur 29, et d'autre part à une partie conductrice formant masse de l'écran d'affichage 3, grâce à l'élément électriquement conducteur 19. En d'autres termes, la connexion de la masse de l'écran d'affichage 3 à la masse du circuit imprimé est fournie par l'intermédiaire de l'élément électriquement conducteur 19, de l'autre élément électriquement conducteur 29 et de la région électriquement conductrice du support 7.

Ainsi, la connexion de l'écran d'affichage 3 à la masse est réalisée sans avoir à ménager une autre ouverture dans le support 7 pour y faire passer un câble de masse. En minimisant le nombre d'ouvertures du support 7 on augmente sa résistance à l'effort.

Les connecteurs 15, 17 relient l'écran d'affichage 3 au circuit imprimé 5. Pour cela, les connecteurs 15, 17 traversent le support 7 par les ouvertures 25 ménagées dans le logement 23.

Le support 7 est par exemple collé à la planche de bord ou fixé par d'autres moyens de fixation.

L'écran d'affichage 3 est par exemple fixé dans le logement 23 du support 7 grâce à de la colle.

L'assemblage de l'écran 3 au support 7 est réalisé par « l'avant ». En d'autres termes, l'écran 3 est assemblé au support 7 sur la partie de la planche de bord située à l'extérieur de cette planche de bord, c'est-à-dire dans l'habitacle du véhicule.

L'écran de protection 9 est fixé à l'écran d'affichage 3 et/ou au support 7 grâce à de la colle ou du ruban adhésif double face.

## Revendications

1. Système d'affichage (1) comprenant :
- un écran d'affichage (3),
- un circuit imprimé (5),
- un support (7) interposé entre l'écran d'affichage (3) et le circuit imprimé (5), l'écran d'affichage (3) comprenant une face électriquement conductrice (13) dirigée vers le support (7), la face électriquement conductrice (13) étant reliée à une région électriquement conductrice du support (7) par un élément électriquement conducteur (19), la région électriquement conductrice du support (7) étant reliée à une masse du circuit imprimé (5), **caractérisé en ce que** le support (7) comprend une plaque présentant un logement accueillant l'écran d'affichage.

2. Système d'affichage selon la revendication 1, dans lequel l'élément électriquement conducteur comprend une patte métallique.

3. Système d'affichage selon la revendication 1 ou 2, dans lequel le support est fabriqué en matériau électriquement conducteur au moins au niveau de la région conductrice.

4. Système d'affichage selon la revendication 3, dans lequel le matériau électriquement conducteur comprend du magnésium.

5. Système d'affichage selon l'une des revendications précédentes, dans lequel la région électriquement conductrice du support est reliée à la masse du circuit imprimé par un autre élément électriquement conducteur.

6. Système d'affichage selon la revendication 5, dans lequel l'autre élément conducteur comprend une autre patte métallique.

7. Système d'affichage selon l'une des revendications précédentes, comprenant un câble électrique connectant l'écran d'affichage au circuit imprimé, le câble électrique passant à travers une ouverture ménagée dans le logement.

8. Système d'affichage selon l'une des revendications précédentes, comprenant un écran de protection fixé sur une face de l'écran d'affichage opposé à face dirigée vers le support.

9. Planche de bord comprenant le système d'affichage selon l'une des revendications 1 à 8, dans laquelle le support est fixé sur la planche de bord.

## Patentansprüche

1. Anzeigesystem (1), umfassend:
- einen Anzeigebildschirm (3),
- eine Leiterplatte (5),
- eine Halterung (7), die zwischen dem Anzeigebildschirm (3) und der Leiterplatte (5) angeordnet ist,
wobei der Anzeigebildschirm (3) eine elektrisch leitende Seite (13) umfasst, die zur Halterung (7) hin gerichtet ist, wobei die elektrisch leitende Seite (13) mit einem elektrisch leitenden Bereich der Halterung (7) über ein elektrisch leitendes Element (19) verbunden ist, wobei der elektrisch leitende Bereich der Halterung (7) mit einer Masse der Leiterplatte (5) verbunden ist, **dadurch gekennzeichnet, dass** die Halterung (7) eine Platte umfasst, die eine Aufnahme aufweist, die den Anzeigebildschirm aufnimmt.

2. Anzeigesystem nach Anspruch 1, bei dem das elektrisch leitende Element eine metallische Lasche umfasst.

3. Anzeigesystem nach Anspruch 1 oder 2, bei dem die Halterung mindestens an dem leitenden Bereich aus elektrisch leitendem Material hergestellt ist.

4. Anzeigesystem nach Anspruch 3, bei dem das elektrisch leitende Material Magnesium umfasst.

5. Anzeigesystem nach einem der vorhergehenden Ansprüche, bei dem der elektrisch leitende Bereich der Halterung mit der Masse der Leiterplatte über ein weiteres elektrisch leitendes Element verbunden ist.

6. Anzeigesystem nach Anspruch 5, bei dem das weitere leitende Element eine weitere metallische Lasche umfasst.

7. Anzeigesystem nach einem der vorhergehenden Ansprüche, umfassend ein Stromkabel, das den Anzeigebildschirm an die Leiterplatte anschließt, wobei das Stromkabel durch eine in der Aufnahme ausgebildete Öffnung hindurch verläuft.

8. Anzeigesystem nach einem der vorhergehenden Ansprüche, umfassend einen Schutzbildschirm, der auf einer Seite des Anzeigebildschirms befestigt ist, die entgegengesetzt zu der zur Halterung hin gerichteten Seite ist.

9. Armaturenbrett, umfassend das Anzeigesystem nach einem der Ansprüche 1 bis 8, bei dem die Halterung auf dem Armaturenbrett befestigt ist.

## Claims

1. Display system (1) comprising:
- a display screen (3),
- a printed circuit (5),
- a support (7) inserted between the display screen (3) and the printed circuit (5),
the display screen (3) comprising an electrically conducting face (13) facing towards the support (7), the electrically conducting face (13) being connected to an electrically conducting region of the support (7) by an electrically conducting element (19), the electrically conducting region of the support (7) being connected to the earth of the printed circuit (5), **characterized in that** the support (7) comprises a plate having a housing accommodating the display screen.

2. Display system according to Claim 1, wherein the electrically conducting element comprises a metal tab.

3. Display system according to Claim 1 or 2, wherein the support is made from an electrically conducting material at least in the vicinity of the conducting region.

4. Display system according to Claim 3, wherein the electrically conducting material contains magnesium.

5. Display system according to one of the preceding claims, wherein the electrically conducting region of the support is connected to the printed circuit earth by another electrically conducting element.

6. Display system according to Claim 5, wherein the other conducting element comprises another metal tab.

7. Display system according to one of the preceding claims, comprising an electric cable connecting the display screen to the printed circuit, the electric cable passing through an opening formed in the housing.

8. Display system according to one of the preceding claims, comprising a protective screen fixed to an opposite face of the display screen to the face that faces towards the support.

9. Dashboard comprising the display system according to one of Claims 1 to 8, wherein the support is fixed to the dashboard.
